# FASCICULE DE BREVET EUROPEEN

(11) **EP 3 423 847 B1**
(45) Date de publication et mention de la délivrance du brevet: **23.03.2022**
(21) Numéro de dépôt: 17706738.6
(22) Date de dépôt: 22.02.2017
(51) Int. Cl.: G01R 31/11

(54) **PROCEDE DE DETECTION DE DEFAUTS NON FRANCS DANS UN CABLE, BASEE SUR L'INTEGRALE D'UN REFLECTOGRAMME**
VERFAHREN ZU DETEKTION VON WEICHEN FEHLERN IN EINEN KABEL, WOBEI DAS VERFAHREN AUF DEM INTEGRAL EINES REFLEKTOGRAMMS BASIERT
METHOD FOR DETECTING SOFT FAULTS IN A CABLE, WHICH METHOD IS BASED ON THE INTEGRAL OF A REFLECTOGRAM

(30) Priorité: 01.03.2016 FR 1651702
(43) Date de publication de la demande: 09.01.2019
(73) Titulaire: Commissariat à l'Énergie Atomique et aux Énergies Alternatives, 75015 Paris (FR)
(72) Inventeur: INCARBONE, Luca, 2502 Biel/Bienne (CH); GALLEGO ROMAN, Miguel, 75014 Paris (FR)
(74) Mandataire: Marks & Clerk France
(86) Numéro de dépôt international: PCT/EP2017/053973
(87) Numéro de publication internationale: WO 2017/148753

(56) Documents cités:
- WO-A1-2013/034565
- WO-A1-2013/057131
- WO-A1-2016/050547
- FR-A1- 2 988 855
- FR-A1- 3 006 769
- GB-A- 1 275 374
- KR-B1- 101 403 346
- US-A1- 2003 125 893
- US-A1- 2006 039 322
- US-A1- 2011 187 381
- US-A1- 2015 253 370
- Lola El Sahmarany: "Méthodes d'amélioration pour le diagnostic de câble par réflectométrie", , 17 décembre 2013 (2013-12-17), pages 1-196, XP055313254, Clermont Ferrand, France Extrait de l'Internet: URL:https://tel.archives-ouvertes.fr/tel-0 0999462/document [extrait le 2016-10-24] cité dans la demande
- FURSE C ET AL: "Noise-Domain Reflectometry for Locating Wiring Faults", IEEE TRANSACTIONS ON ELECTROMAGNETIC COMPATIBILITY, IEEE SERVICE CENTER, NEW YORK, NY, US, vol. 47, no. 1, 1 février 2005 (2005-02-01), pages 97-104, XP011127068, ISSN: 0018-9375, DOI: 10.1109/TEMC.2004.842109
- SMITH P ET AL: "Analysis of spread spectrum time domain reflectometry for wire fault location", IEEE SENSORS JOURNAL, IEEE SERVICE CENTER, NEW YORK, NY, US, vol. 5, no. 6, 1 décembre 2005 (2005-12-01), pages 1469-1478, XP001512966, ISSN: 1530-437X, DOI: 10.1109/JSEN.2005.858964
- GEIGER H ET AL: "LOW-COST HIGH-RESOLUTION TIME-DOMAIN REFLECTOMETRY FOR MONITORING THE RANGE OF REFLECTIVE POINTS", JOURNAL OF LIGHTWAVE TECHNOLOGY, IEEE SERVICE CENTER, NEW YORK, NY, US, vol. 13, no. 7, 1 juillet 1995 (1995-07-01), pages 1282-1288, XP000597647, ISSN: 0733-8724, DOI: 10.1109/50.400686
- JAMES R ANDREWS: "Automatic Network Measurements in the Time Domain", PROCEEDINGS OF THE IEEE, IEEE. NEW YORK, US, vol. 66, no. 4, 1 avril 1978 (1978-04-01), pages 414-423, XP001458321, ISSN: 0018-9219
- BIESEN VAN L P ET AL: "HIGH ACCURACY LOCATION OF FAULTS ON ELECTRICAL LINES USING DIGITAL SIGNAL PROCESSING", IEEE TRANSACTIONS ON INSTRUMENTATION AND MEASUREMENT, IEEE SERVICE CENTER, PISCATAWAY, NJ, US, vol. 39, no. 1, 1 février 1990 (1990-02-01), pages 175-179, XP000101432, ISSN: 0018-9456, DOI: 10.1109/19.50439
- PINTELON R ET AL: "IDENTIFICATION OF TRANSFER FUNCTIONS WITH TIME DELAY AND ITS APPLICATION TO CABLE FAULT LOCATION", IEEE TRANSACTIONS ON INSTRUMENTATION AND MEASUREMENT, IEEE SERVICE CENTER, PISCATAWAY, NJ, US, vol. 39, no. 3, 1 juin 1990 (1990-06-01), pages 479-484, XP000129123, ISSN: 0018-9456, DOI: 10.1109/19.106276
- LAYANE ABBOUD ET AL: "Utilization of matched pulses to improve fault detection in wire networks", INTELLIGENT TRANSPORT SYSTEMS TELECOMMUNICATIONS,(ITST),2009 9TH INTERNATIONAL CONFERENCE ON, IEEE, PISCATAWAY, NJ, USA, 20 octobre 2009 (2009-10-20), pages 543-548, XP031619128, ISBN: 978-1-4244-5346-7

## Description

L'invention concerne le domaine des systèmes de diagnostic filaires basés sur le principe de la réflectométrie. Elle a pour objet un procédé de détection de défauts non francs dans un câble, basé sur l'exploitation de l'intégrale d'un réflectogramme.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde ou signal de référence, qui est le plus souvent de haute fréquence ou large bande, est injecté en un ou plusieurs endroits du câble à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'invention entre dans le champ d'application des méthodes de réflectométrie pour le diagnostic filaire et s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie en un point du câble et de mesurer sa réflexion au même point ou en un autre point.

Les méthodes de réflectométrie temporelle connues sont particulièrement adaptées à la détection de défauts francs dans un câble, tel un court circuit ou un circuit ouvert ou plus généralement une modification locale significative de l'impédance du câble. La détection du défaut se fait par la mesure de l'amplitude du signal réfléchi sur ce défaut qui est d'autant plus importante et donc détectable, que le défaut est important.

A l'inverse, un défaut non franc, par exemple résultant d'une dégradation superficielle de la gaine du câble de l'isolant ou du conducteur, engendre un pic d'amplitude faible sur le signal de réflectométrie réfléchi et est par conséquent plus difficilement détectable par des méthodes temporelles classiques. Plus généralement, un défaut non franc peut être provoqué par un frottement, un pincement ou encore un phénomène de corrosion qui vient affecter la gaine du câble, l'isolant ou le conducteur.

La détection et la localisation d'un défaut non franc sur un câble est un problème important pour le monde industriel car un défaut apparait en général d'abord comme un défaut superficiel mais peut, avec le temps, évoluer vers un défaut plus impactant. Pour cette raison notamment, il est utile de pouvoir détecter l'apparition d'un défaut dès son apparition et à un stade où son impact est superficiel afin d'anticiper son évolution en un défaut plus important.

La faible amplitude des réflexions associées au passage du signal à travers un défaut non franc entraine également un problème potentiel de fausses détections. En effet, il peut être difficile de discriminer un pic de faible amplitude dans un réflectogramme qui peut résulter soit d'un défaut sur le câble, soit d'un bruit de mesure. Ainsi, des faux positifs peuvent apparaître qui correspondent non pas à des défauts mais qui résultent du bruit de mesure ou d'inhomogénéités du câble.

L'état de l'art comporte plusieurs méthodes de détection de défauts non francs basées sur le principe de la réflectométrie.

La demande de brevet français du Demandeur publiée sous le numéro FR2981752 propose une méthode de post-traitement d'un réflectogramme basée sur la transformée mathématique de Wigner-Ville. La méthode consiste en une analyse temps-fréquence du réflectogramme afin d'accentuer les composantes correspondantes aux défauts recherchés. Un inconvénient de cette méthode est sa complexité importante pour des équipements embarqués

La demande de brevet français du Demandeur publiée sous le numéro FR3006769 propose une approche différente basée sur un traitement du signal mesuré dans le domaine fréquentiel afin d'estimer certains paramètres caractéristiques de la propagation du signal dans le câble. La détection de défauts non francs est faite en analysant les paramètres estimés.

On connait également les demandes de brevet français du Demandeur déposées respectivement sous les numéros FR1459402 et FR1554632. La première propose une méthode de corrélation autoadaptative entre le signal réfléchi et le signal injecté tandis que la seconde se concentre sur une recherche des passages à zéro du réflectogramme et une comparaison de l'énergie du signal calculée de part et d'autre du passage à zéro. On peut citer également la méthode dite de corrélation soustractive décrite dans le document « Méthodes d'amélioration pour le diagnostic de câble par réflectométrie », Lola El Sahmarany, Université Biaise Pascal - Clermont-Ferrand II, 2013.

Ces dernières méthodes présentent des résultats améliorés pour la détection de défauts non francs mais peuvent cependant engendrer un nombre non négligeable de fausses détections ou faux positifs du fait de la difficulté de discriminer les pics de faible amplitude associés à des défauts et ceux associés à du bruit de mesure ou à des inhomogénéités natives du câble.

On connait par ailleurs les méthodes décrites dans les demandes de brevet US 2006/039322 et GB 1275374.

L'invention propose une nouvelle méthode de détection de défauts non francs basée sur un post-traitement appliqué à l'intégrale du réflectogramme mesuré.

L'invention présente l'avantage de limiter les fausses détections et d'être peu complexe à mettre en œuvre, facilitant ainsi son implémentation dans un dispositif embarqué.

L'invention a ainsi pour objet un procédé de détection de défauts non francs dans une ligne de transmission comprenant les étapes suivantes :
- Acquérir un signal de mesure, appelé réflectogramme temporel, caractéristique de la réflexion d'un signal de référence préalablement injecté dans la ligne,
- Calculer l'intégrale du réflectogramme temporel,
- Sélectionner, parmi les échantillons de l'intégrale du réflectogramme temporel, un premier échantillon P₁, un deuxième échantillon P₂, retardé d'un premier retard k₁ par rapport au premier échantillon P₁ et un troisième échantillon P₃, retardé d'un second retard k₂ par rapport au deuxième échantillon P₂,
- Calculer une première distance égale à la différence en valeur absolue entre la valeur du second échantillon P₂ et la valeur de l'un quelconque du premier échantillon P₁ ou du troisième échantillon P₃,
- Calculer une seconde distance égale à la différence en valeur absolue entre la valeur du premier échantillon P₁ et du troisième échantillon P₃,
- Effectuer une première comparaison de la première distance à la seconde distance pondérée par un coefficient de pondération β,
- Déduire du résultat de la première comparaison une information sur l'existence d'un défaut non franc en une position du câble correspondant à l'abscisse temporelle du second échantillon P₂.

Selon un mode particulier de réalisation, le procédé selon l'invention comprend en outre les étapes suivantes :
- Effectuer une seconde comparaison de la première distance à un seuil de détection a,
- Déduire du résultat de la première comparaison et de la seconde comparaison une information sur l'existence d'un défaut non franc en une position du câble correspondant à l'abscisse temporelle du second échantillon P₂.

Selon un aspect particulier de l'invention, le premier retard k₁ et le second retard k₂ sont déterminés au moins en fonction de la largeur du premier pic de désadaptation mesuré sur le réflectogramme temporel.

Selon un aspect particulier de l'invention, on itère le procédé en faisant varier le premier échantillon P₁ sur une pluralité d'échantillons de l'intégrale du réflectogramme temporel en conservant les valeurs du premier retard k₁ et du second retard k₂ fixes au cours des itérations.

Selon un aspect particulier de l'invention, le premier retard k₁ est égal au second retard k_{2.}

Selon un aspect particulier de l'invention, le seuil de détection α est configuré au moins en fonction d'un paramètre parmi le rapport signal à bruit sur le premier signal r(t) et la sévérité du défaut non franc visé.

Selon un aspect particulier de l'invention, la valeur du coefficient de pondération β est prise dans l'intervalle [3 ; 9].

Selon un aspect particulier de l'invention, le réflectogramme temporel est remplacé par l'intercorrélation entre le premier signal r(t) de mesure et le signal de référence s(t).

Selon un mode particulier de réalisation, le procédé selon l'invention comprend une étape de diagnostic consistant à conclure à la présence d'un défaut non franc en une position du câble correspondant à l'abscisse temporelle du second échantillon P₂ si la première distance est supérieure au seuil de détection α et si la première distance est supérieure à la seconde distance pondérée par le coefficient de pondération β.

Selon un mode particulier de réalisation, le procédé selon l'invention comprend une étape de diagnostic consistant à conclure à l'absence d'un défaut non franc en une position du câble correspondant à l'abscisse temporelle du second échantillon P₂ si la première distance est inférieure au seuil de détection α et si la première distance est inférieure à la seconde distance pondérée par le coefficient de pondération β.

L'invention a aussi pour objet un dispositif de détection de défauts non francs dans un câble comprenant un appareil de mesure, en un point du câble, d'un signal rétro-propagé dans le câble et un calculateur configuré pour exécuter le procédé de détection de défauts non francs dans un câble selon l'invention.

L'invention a aussi pour objet un système de réflectométrie comprenant un dispositif d'injection, en un point du câble, d'un signal de référence et un dispositif de détection de défauts non francs dans un câble selon l'invention.

L'invention a aussi pour objet un programme d'ordinateur comportant des instructions pour l'exécution du procédé de détection de défauts non francs dans un câble selon l'invention, lorsque le programme est exécuté par un processeur.

L'invention a aussi pour objet un support d'enregistrement lisible par un processeur sur lequel est enregistré un programme comportant des instructions pour l'exécution du procédé de détection de défauts non francs dans un câble selon l'invention, lorsque le programme est exécuté par un processeur.

D'autres caractéristiques et avantages de la présente invention apparaîtront mieux à la lecture de la description qui suit en relation aux dessins annexés qui représentent :
- La figure 1, un schéma illustrant le principe connu de la réflectométrie temporelle et son application à la détection d'un défaut non franc,
- La figure 2, un exemple de réflectogramme illustrant l'allure de la signature d'un défaut non franc,
- La figure 3, un organigramme détaillant les étapes de mise en œuvre du procédé selon l'invention,
- Les figures 4a,4b,4c plusieurs diagrammes illustrant certaines étapes du procédé selon l'invention,
- La figure 5, un schéma d'un exemple de réalisation d'un dispositif de détection de défauts non francs selon l'invention.

Un défaut non franc introduit généralement une modification locale des caractéristiques électriques d'une ligne de transmission, par exemple d'un câble. La dégradation physique, même superficielle, de la ligne entraine en particulier une modification locale de l'impédance caractéristique du câble, ce qui entraine une modification du coefficient de réflexion à l'endroit du défaut.

Le terme défaut non franc vise ici tout défaut impactant superficiellement un câble de sorte à engendrer une variation de l'impédance caractéristique localement. En particulier, de tels défauts incluent une éraflure ou une usure de la gaine, du diélectrique mais aussi le début de la dégradation du conducteur métallique, la compression d'un câble, le frottement ou encore la corrosion. Ces dégradations peuvent, au premier abord, sembler bénignes et sans répercussions notables pour le système. Cependant, si rien n'est fait, les contraintes mécaniques, environnementales ou encore le vieillissement du câble, feront évoluer un défaut non franc vers un défaut franc, dont les conséquences, tant économiques que matérielles, peuvent être considérables. Détecter les défauts naissants permet une meilleure gestion de la maintenance et donc une réduction des coûts de réparation.

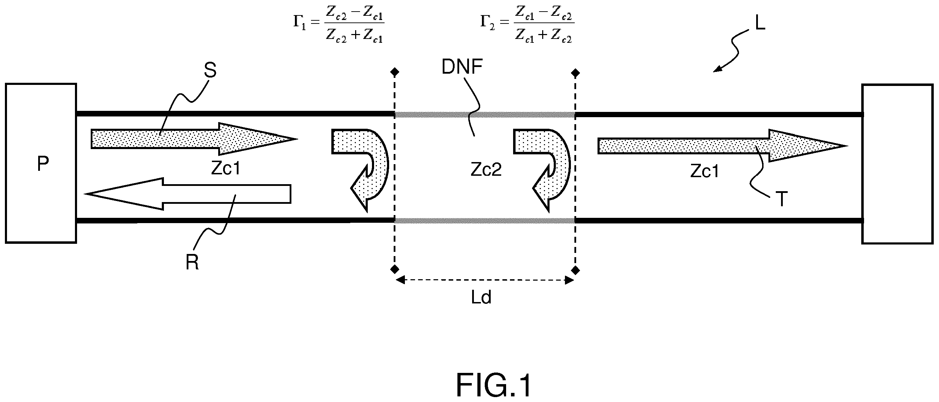

La figure 1 schématise le principe de fonctionnement d'une méthode de diagnostic par réflectométrie appliquée à une ligne de transmission L présentant un défaut non-franc DNF.

Un signal de référence S est injecté dans la ligne de transmission en un point P. Le signal réfléchi R est mesuré au même point P (ou en un autre point de la ligne). Ce signal se propage dans la ligne et rencontre, au cours de sa propagation, une première discontinuité d'impédance à l'entrée du défaut non franc DNF. Le signal se réfléchit sur cette discontinuité avec un coefficient de réflexion Γ₁ . Si l'impédance caractéristique *Z*_{*c*2} dans la zone du défaut non franc DNF est inférieure à l'impédance caractéristique *Z*_{*c*1} avant l'apparition du défaut, alors le coefficient de réflexion Γ₁ est négatif et se traduit par un pic d'amplitude négative dans le signal réfléchi R. Dans le cas inverse, le coefficient de réflexion Γ₁ est positif et se traduit par un pic d'amplitude positive dans le signal réfléchi R.

La partie transmise T du signal incident S continue de se propager dans la ligne et rencontre ensuite une deuxième discontinuité d'impédance créant une deuxième réflexion du signal incident avec un coefficient de réflexion Γ₂ de signe opposé au premier coefficient de réflexion Γ₁. Si Γ₁ < 0 alors Γ₂ > 0. Si Γ₁ > 0 alors Γ₂ < 0.

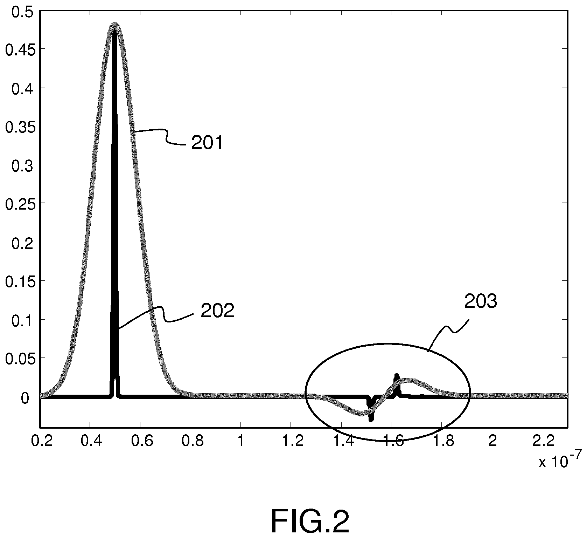

Ainsi, en observant le signal réfléchi R, la signature du défaut non franc DNF est caractérisée par deux pics successifs de signes inversés comme le montre la figure 2.

La figure 2 représente un réflectogramme temporel qui correspond soit directement à la mesure du signal réfléchi R, soit à l'intercorrélation entre le signal réfléchi R et le signal injecté dans le câble S.

Dans le cas où le signal de référence injecté est une impulsion temporelle, le réflectogramme peut correspondre directement à la mesure du signal réfléchi R. Dans le cas où le signal de référence injecté est un signal plus complexe alors le réflectogramme est obtenu en inter-corrélant le signal réfléchi R et le signal injecté S.

Sur la figure 2, on a représenté deux réflectogrammes 201,202 correspondants à deux durées d'impulsion différentes pour le signal injecté dans le câble. La courbe 201 correspond à une durée d'impulsion 2.ΔT très supérieure au temps de traversée, par le signal, du défaut non franc DNF. La longueur du défaut étant notée Ld, cette durée vaut Ld/V, avec V la vitesse de propagation du signal dans le câble. La courbe 202 correspond à une durée d'impulsion 2.ΔT très inférieure au temps de traversée, par le signal, du défaut non franc DNF.

Dans les deux cas, la signature 203 du défaut non franc, dans le réflectogramme, est toujours composée de la succession d'un premier pic et d'un second pic dont les signes sont inversés. Cette propriété est exploitée par l'invention pour améliorer la détection de tels défauts.

La distance entre les deux pics représente la longueur du défaut non franc et leur amplitude représente la sévérité du défaut non franc. En effet, plus la variation de l'impédance caractéristique est importante, plus l'amplitude de la signature du défaut non franc dans le réflectogramme est également importante.

Comme cela est connu dans le domaine des méthodes de diagnostic par réflectométrie, la position d_{DNF} du défaut non franc sur le câble, autrement dit sa distance au point P d'injection du signal, peut être directement obtenue à partir de la mesure, sur le réflectogramme temporel de la figure 2, de la durée t_{DNF} entre le premier pic d'amplitude relevé sur le réflectogramme (à l'abscisse 0,5 sur l'exemple de la figure 2) et le pic d'amplitude 203 correspondant à la signature du défaut non franc.

Différentes méthodes connues sont envisageables pour déterminer la position d_{DNF}. Une première méthode consiste à appliquer la relation liant distance et temps : d_{DNF} = V.t_{DNF} où V est la vitesse de propagation du signal dans le câble. Une autre méthode possible consiste à appliquer une relation de proportionnalité du type d_{DNF}/ t_{DNF} = L/t₀ où L est la longueur du câble et t₀ est la durée, mesurée sur le réflectogramme, entre le pic d'amplitude correspondant à la discontinuité d'impédance au point d'injection et le pic d'amplitude correspondant à la réflexion du signal sur l'extrémité du câble.

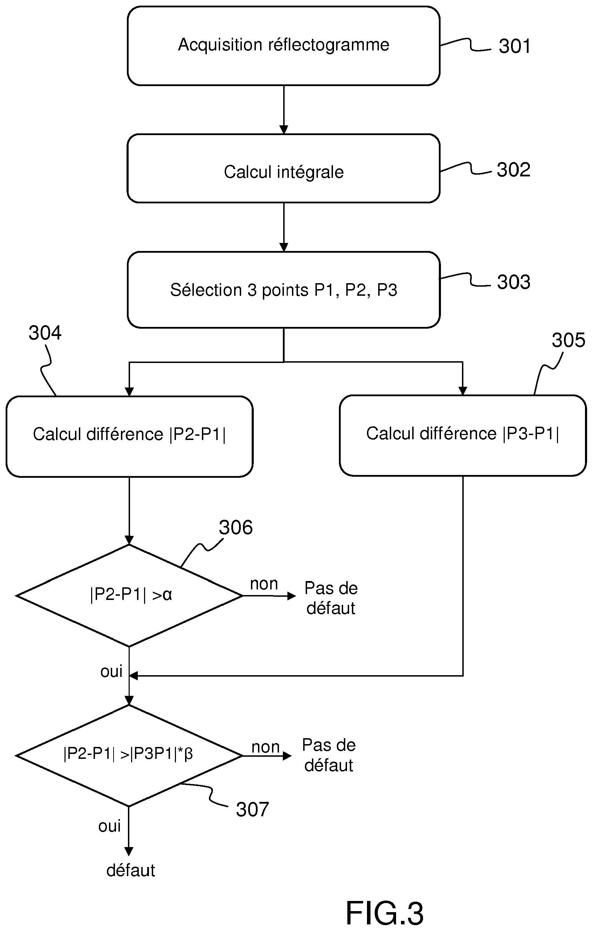

La figure 3 détaille les étapes de mise en œuvre de la méthode de détection de défauts non francs selon l'invention.

Le procédé selon l'invention est appliqué à un réflectogramme temporel qui traduit les réflexions d'un signal de référence injecté dans le câble, sur les discontinuités d'impédance qu'il rencontre lors de sa propagation. La nature du réflectogramme dépend du type de signal de référence envisagé. De façon générale, quelle que soit la forme du signal, le réflectogramme peut être obtenu à partir d'une mesure du signal rétropropagé dans le câble puis d'une inter-corrélation de cette mesure avec le signal de référence qui a été injecté dans le câble. Dans le cas où le signal de référence utilisé est une impulsion temporelle, par exemple une impulsion de forme Gaussienne, l'étape d'inter-corrélation de la mesure avec le signal de référence n'est pas nécessaire.

Ainsi, le procédé débute par l'acquisition ou la construction 301 d'un réflectogramme temporel à partir d'au moins une mesure d'un signal rétropropagé dans le câble.

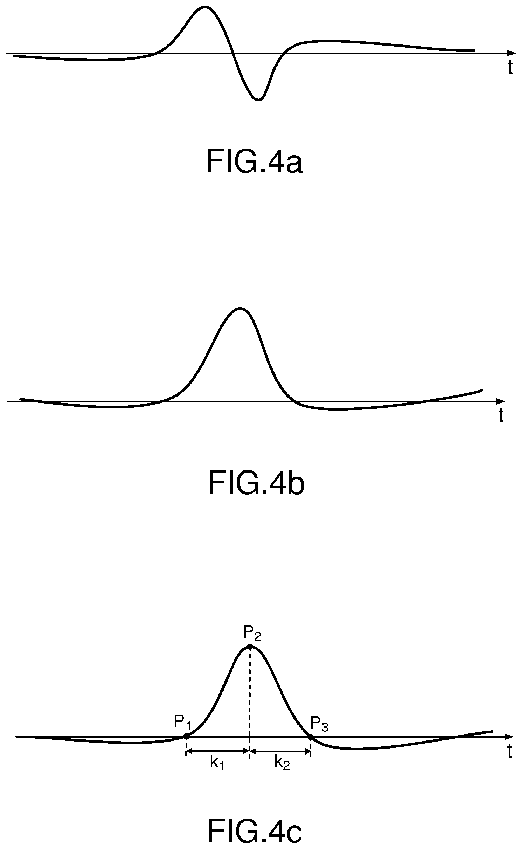

Un exemple de réflectogramme temporel est représenté à la figure 4a. Ce réflectogramme comporte une signature caractéristique d'un défaut non franc comportant un premier pic de signe positif suivi d'un second pic de signe opposé négatif et d'amplitude sensiblement identique au premier pic.

Dans une étape optionnelle, non représentée à la figure 4a, on calcule la différence entre le réflectogramme temporel mesuré et un réflectogramme temporel mesuré à un instant antérieur, par exemple à la mise en place du câble, afin d'éliminer les inhomogénéités présentes dans le câble dès sa conception. Cette étape permet également le suivi de l'évolution des défauts impactant le câble en effectuant une analyse différentielle.

Le procédé se poursuit dans une deuxième étape 302 consistant à calculer l'intégrale INT du réflectogramme. L'intégrale est calculée numériquement, par exemple en calculant la somme des échantillons du réflectogramme entre l'instant 0 et l'instant courant t. Un exemple de résultat du calcul de l'intégrale INT du réflectogramme de la figure 4a est représenté sur la figure 4b. On remarque qu'après calcul de l'intégrale, les deux pics de signes inversés caractéristiques d'un défaut non franc sont convertis en un pic unique de durée double par rapport à la durée de chacun des deux pics de la signature du défaut dans le réflectogramme.

L'invention vise à exploiter la forme caractéristique de la signature d'un défaut non franc, après calcul de l'intégrale du réflectogramme, en recherchant cette forme afin de localiser un défaut non franc avec précision.

Pour cela, les étapes suivantes 303,304,305,306,307 peuvent être itérées pour tous les échantillons de l'intégrale INT du réflectogramme afin de rechercher la présence d'un défaut non franc sur toute la longueur du câble. Alternativement, ces étapes peuvent être exécutées uniquement pour un intervalle temporel donné de l'intégrale INT du réflectogramme, par exemple un intervalle correspondant à une zone du câble dans laquelle un défaut a été pré-localisé.

L'étape 303 consiste à sélectionner trois échantillons P1,P2,P3 de l'intégrale INT espacés respectivement d'une durée k1 et d'une durée k2 comme illustré à la figure 4c. Les durées k1 et k2 sont des paramètres de l'invention et sont fixées une fois pour toutes pour le traitement de l'ensemble du réflectogramme. Ainsi, les trois points P1,P2,P3 peuvent parcourir la courbe intégrale INT du réflectogramme, un but de l'invention étant de détecter les configurations pour lesquelles le second point P2 coïncide avec le sommet du pic de la signature d'un défaut, tandis que le premier point P1 et le dernier point P3 coïncident respectivement avec le début et la fin du pic. Cette configuration est représentée à la figure 4c. Il convient de noter que le pic d'amplitude caractéristique de la présence d'un défaut non franc dans l'intégrale INT du réflectogramme peut également être de signe négatif (configuration opposée à celle de la figure 4c).

Les durées k1 et k2 sont déterminées de sorte à ce que le retard entre le dernier point P3 et le premier point P1 soit sensiblement égal à la durée de la signature d'un défaut que l'on souhaite détecter, dans l'intégrale du réflectogramme.

Dans le cas où le signal de référence utilisé est une impulsion temporelle, les durées k1 et k2 sont déterminées en fonction de la durée de l'impulsion du signal de référence injecté dans le câble ou encore de la fréquence de ce signal. Dans ce cas, la durée totale k1+k2 peut être choisie, par exemple, égale au double de la durée de l'impulsion du signal de référence injecté dans le câble ou de l'impulsion associée au premier pic de désadaptation sur le point d'injection du câble dans le réflectogramme.

Dans le cas plus général où le signal de référence utilisé a une forme quelconque, la durée totale k1+k2 peut être déterminée en mesurant la largeur du premier pic de désadaptation dans le réflectogramme obtenu après inter-corrélation entre le signal de référence et le signal réfléchi mesuré.

Un mode de réalisation possible de l'invention consiste à choisir k1=k2 pour rechercher des pics d'amplitude de forme symétrique.

Dans une variante de réalisation, la durée k2 peut être prise égale à une valeur supérieure à celle de la durée k1 afin de prendre en compte les phénomènes de dispersion, qui interviennent en particulier aux hautes fréquences, pour détecter des défauts situés à une grande distance du point d'injection. En effet, la symétrie de la double impulsion, caractéristique de la signature d'un défaut non franc dans un réflectogramme, peut être distordue du fait de la variabilité potentielle de la vitesse de propagation du signal en fonction de la fréquence.

Dans une étape 304, on calcule une première différence en valeur absolue entre le deuxième échantillon P2 et le premier échantillon P1. Alternativement, le premier échantillon P1 peut être remplacé par le troisième échantillon P3.

Dans une étape 305, on calcule également une seconde différence en valeur absolue entre le troisième échantillon P3 et le premier échantillon P1.

Le procédé se poursuit avec deux étapes de comparaison 306,307.

La première étape 306 consiste à comparer la première différence calculée à l'étape 304 à un seuil de détection paramétrable a. Ce test permet de discriminer un défaut non franc d'un simple artefact de mesure lié au bruit. Le seuil de détection α dépend de la sévérité du défaut que l'on cherche à détecter ainsi que du rapport signal à bruit sur la mesure. La première différence |P2-P1| (ou |P2-P3|) donne une information sur l'amplitude du pic caractéristique d'un défaut non franc dans l'intégrale INT du réflectogramme.

Si la première différence est inférieure au seuil de détection α, le procédé conclut à l'absence de défaut au point du câble correspondant à l'abscisse temporelle du second point P2 sélectionné. On rappelle ici qu'il existe une correspondance directe entre les abscisses temporelles des points d'un réflectogramme (ou de l'intégrale d'un réflectogramme) et la distance entre le point d'injection du signal de référence et un point du câble. Les deux informations sont liées par la relation d=V.t où V est la vitesse de propagation du signal dans le câble, d est une distance entre le point d'injection et un point du câble et t est l'abscisse temporelle d'un point du réflectogramme.

A l'inverse, si la première différence est supérieure ou égale au seuil de détection α, alors le procédé passe à une seconde étape de comparaison 307. Dans cette étape 307, on compare la première différence calculée à l'étape 304 avec la seconde différence calculée à l'étape 305 et multipliée par un coefficient de pondération β. Ce second test permet de détecter la forme de la signature d'un défaut non franc dans l'intégrale INT du réflectogramme. Le coefficient de pondération β dépend de la forme de l'impulsion caractéristique d'un défaut non franc dans l'intégrale INT du réflectogramme. La valeur de ce coefficient de pondération est fixée expérimentalement. Une valeur préférée de ce coefficient, obtenue expérimentalement, est comprise dans l'intervalle [3 ; 9]. La comparaison de la première différence |P2-P1| (ou |P2-P3|) avec la seconde différence |P3-P1| pondérée par un coefficient β permet de caractériser la forme de l'impulsion.

Si la première différence est inférieure à la seconde différence pondérée par le coefficient β, alors le procédé conclut à l'absence de défaut au point du câble correspondant à l'abscisse temporelle du second point P2 sélectionné.

A l'inverse, si la première différence est supérieure ou égale à la seconde différence pondérée par le coefficient β, alors le procédé conclut à la présence d'un défaut non franc au point du câble correspondant à l'abscisse temporelle du second point P2 sélectionné.

Les étapes de test 306 et 307 peuvent être exécutées dans l'ordre indiqué ci-dessus ou dans l'ordre inverse, c'est-à-dire en appliquant d'abord le test 307 vis-à-vis du coefficient β puis le test 306 associé au seuil de détection α.

Selon une variante particulière de réalisation de l'invention, la première étape de test 306 peut être rendue optionnelle, le procédé selon l'invention ne comprenant alors que l'étape de test 307.

L'invention présente l'avantage d'être peu complexe à implémenter car elle ne nécessite que des calculs simples (addition, soustraction et comparaison). Elle peut ainsi être facilement embarquée dans un équipement de diagnostic filaire portatif. En outre, l'invention permet de localiser précisément un défaut non franc en recherchant le sommet du pic d'amplitude caractéristique de la signature d'un tel défaut dans le domaine de l'intégrale du réflectogramme.

L'invention peut être appliquée à tout type de signaux compatibles d'un diagnostic par réflectométrie ainsi qu'à tout type de câble pour lequel le problème de détection de défauts superficiels existe.

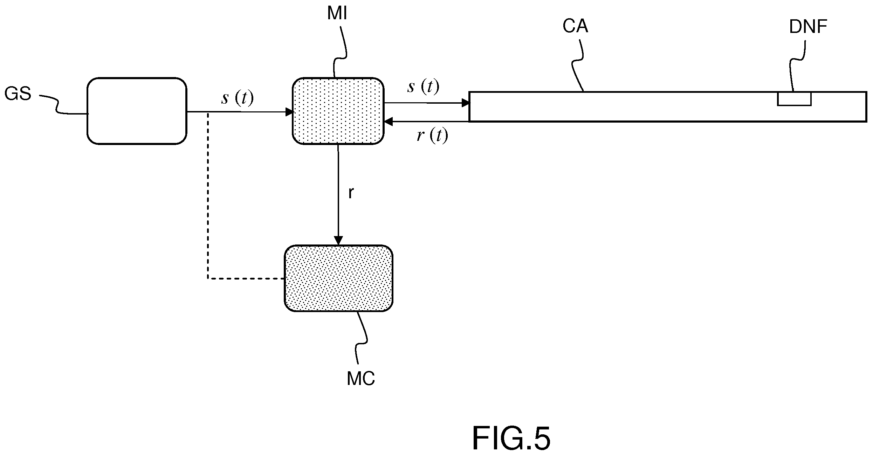

La figure 5 schématise, sur un synoptique, un exemple de système de réflectométrie apte à mettre en œuvre le procédé selon l'invention.

Un système de réflectométrie, ou réflectomètre, comporte au moins un générateur de signal GS, pour générer un signal de test s et l'injecter dans le câble à analyser CA qui comporte un défaut non franc DNF, un équipement de mesure MI pour mesurer le signal réfléchi r dans le câble CA et un composant électronique MC de type circuit intégré, tel un circuit à logique programmable, par exemple de type FPGA ou un micro-contrôleur, par exemple un processeur de signal numérique, qui reçoit la mesure du signal réfléchi r(t) et est configuré pour exécuter le procédé selon l'invention afin de détecter et localiser un ou plusieurs défauts non francs. Le composant électronique MC peut également comporter à la fois un circuit intégré, par exemple pour réaliser l'acquisition du signal réfléchi, et un micro-contrôleur pour exécuter les étapes de traitement requises par l'invention.

L'injection du signal de test s dans le câble peut être réalisée par un dispositif de couplage (non représenté à la figure 5) qui peut être un coupleur à effet capacitif ou inductif ou encore à l'aide d'une connexion ohmique. Le dispositif de couplage peut être réalisée par des connecteurs physiques qui relient le générateur de signal au câble ou par des moyens sans contact, par exemple en utilisant un cylindre métallique dont le diamètre interne est sensiblement égal au diamètre externe du câble et qui produit un effet de couplage capacitif avec le câble.

L'acquisition du signal réfléchi dans le câble peut également être réalisée au moyen d'un dispositif de couplage du type décrit précédemment.

Le système de réflectométrie peut également comporter un convertisseur numérique-analogique disposé entre le générateur de signal de test, dans le cas où il s'agit d'un signal numérique, et le coupleur d'injection.

Le système de réflectométrie peut également comporter un convertisseur analogique-numérique disposé entre le coupleur de mesure du signal réfléchi et l'équipement de mesure MI ou le composant électronique MC aux fins de numériser le signal analogique mesuré.

En outre, une unité de traitement (non représentée à la figure 5), de type ordinateur, assistant numérique personnel ou autre est utilisée pour piloter le système de réflectométrie selon l'invention et afficher les résultats des mesures sur une interface homme-machine.

Les résultats affichés peuvent comprendre un ou plusieurs réflectogrammes calculés à l'aide du procédé selon l'invention et/ou une information relative à l'existence et à la localisation d'un défaut sur le câble également produite par le procédé selon l'invention.

Selon un mode de réalisation particulier, le signal de test s injecté peut également être fourni au composant MC lorsque les traitements réalisés nécessitent la connaissance du signal injecté, notamment lorsque ceux-ci incluent une étape d'intercorrélation entre le signal de test s et le signal réfléchi r.

L'injection du signal dans le câble et la mesure du signal réfléchi peuvent être réalisées par un seul et même composant mais aussi par deux composants distincts, notamment lorsque le point d'injection et le point de mesure sont dissociés.

Le système décrit à la figure 5 peut être mis en œuvre par une carte électronique sur laquelle sont disposés les différents composants. La carte peut être connectée au câble par un coupleur.

En outre, une unité de traitement, de type ordinateur, assistant numérique personnel ou autre dispositif électronique ou informatique équivalent peut être utilisé pour piloter le dispositif de réflectométrie et afficher les résultats des calculs effectués par le composant MC sur une interface homme-machine, en particulier les informations de détection et localisation de défauts sur le câble.

Le procédé selon l'invention peut être implémenté sur le composant MC à partir d'éléments matériels et/ou logiciels.

Le procédé selon l'invention peut être implémenté directement par un processeur embarqué ou dans un dispositif spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gâte Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro contrôleur par exemple) exécutant un programme comprenant une séquence d'instructions, ou sur une machine de calcul dédiée (par exemple un ensemble de portes logiques comme un FPGA ou un ASIC, ou tout autre module matériel).

Le procédé selon l'invention peut également être mis en œuvre exclusivement en tant que programme d'ordinateur, le procédé étant alors appliqué à une mesure de réflectométrie r préalablement acquise à l'aide d'un dispositif de réflectométrie usuel. Dans un tel cas, l'invention peut être mise en œuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués ("*Cloud computing"*)*,* éventuellement selon des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

## Revendications

1. Procédé de détection de défauts non francs dans une ligne de transmission (L) comprenant les étapes suivantes :
- Acquérir (301) un signal (R) de mesure, appelé réflectogramme temporel, caractéristique de la réflexion d'un signal de référence (S) préalablement injecté dans la ligne (L),
- Calculer (302) l'intégrale (INT) du réflectogramme temporel,
- Sélectionner (303), parmi les échantillons de l'intégrale (INT) du réflectogramme temporel, un premier échantillon P₁, un deuxième échantillon P₂, retardé d'un premier retard k₁ par rapport au premier échantillon P₁ et un troisième échantillon P₃, retardé d'un second retard k₂ par rapport au deuxième échantillon P₂,
- Calculer (304) une première distance égale à la différence en valeur absolue entre la valeur du second échantillon P₂ et la valeur de l'un quelconque du premier échantillon P₁ ou du troisième échantillon P₃,
- Calculer (305) une seconde distance égale à la différence en valeur absolue entre la valeur du premier échantillon P₁ et du troisième échantillon P₃,
- Effectuer une première comparaison (307) de la première distance à la seconde distance pondérée par un coefficient de pondération β,
- Déduire du résultat de la première comparaison (307) une information sur l'existence d'un défaut non franc en une position du câble correspondant à l'abscisse temporelle du second échantillon P₂.

2. Procédé de détection de défauts non francs dans un câble selon la revendication 1 comprenant en outre les étapes suivantes :
- Effectuer une seconde comparaison (306) de la première distance à un seuil de détection α,
- Déduire du résultat de la première comparaison (307) et de la seconde comparaison (306) une information sur l'existence d'un défaut non franc en une position du câble correspondant à l'abscisse temporelle du second échantillon P₂.

3. Procédé de détection de défauts non francs dans un câble selon l'une des revendications précédentes dans lequel le premier retard k₁ et le second retard k₂ sont déterminés au moins en fonction de la largeur du premier pic de désadaptation mesuré sur le réflectogramme temporel.

4. Procédé de détection de défauts non francs dans un câble selon l'une des revendications précédentes dans lequel on itère le procédé en faisant varier le premier échantillon P₁ sur une pluralité d'échantillons de l'intégrale (INT) du réflectogramme temporel en conservant les valeurs du premier retard k₁ et du second retard k₂ fixes au cours des itérations.

5. Procédé de détection de défauts non francs dans un câble selon l'une des revendications précédentes dans lequel le premier retard k₁ est égal au second retard k_{2.}

6. Procédé de détection de défauts non francs dans un câble selon l'une des revendications précédentes dans lequel le seuil de détection α est configuré au moins en fonction d'un paramètre parmi le rapport signal à bruit sur le premier signal r(t) et la sévérité du défaut non franc visé.

7. Procédé de détection de défauts non francs dans un câble selon l'une des revendications précédentes dans lequel la valeur du coefficient de pondération β est prise dans l'intervalle [3 ; 9].

8. Procédé de détection de défauts non francs dans un câble selon l'une des revendications précédentes dans lequel le réflectogramme temporel est remplacé par l'intercorrélation entre le premier signal r(t) de mesure et le signal de référence s(t).

9. Procédé de détection de défauts non francs dans un câble selon l'une des revendications précédentes comprenant une étape de diagnostic consistant à conclure à la présence d'un défaut non franc en une position du câble correspondant à l'abscisse temporelle du second échantillon P₂ si la première distance est supérieure au seuil de détection α et si la première distance est supérieure à la seconde distance pondérée par le coefficient de pondération β.

10. Procédé de détection de défauts non francs dans un câble selon l'une des revendications précédentes comprenant une étape de diagnostic consistant à conclure à l'absence d'un défaut non franc en une position du câble correspondant à l'abscisse temporelle du second échantillon P₂ si la première distance est inférieure au seuil de détection α et si la première distance est inférieure à la seconde distance pondérée par le coefficient de pondération β.

11. Dispositif de détection de défauts non francs dans un câble (CA) comprenant un appareil de mesure (MI), en un point du câble (CA), d'un signal rétro-propagé dans le câble et un calculateur (MC) configuré pour exécuter le procédé de détection de défauts non francs dans un câble selon l'une quelconque des revendications 1 à 10.

12. Système de réflectométrie comprenant un dispositif d'injection (GS), en un point du câble, d'un signal de référence et un dispositif de détection de défauts non francs dans un câble (CA) selon la revendication 11.

13. Programme d'ordinateur comportant des instructions pour l'exécution du procédé de détection de défauts non francs dans un câble selon l'une quelconque des revendications 1 à 10, lorsque le programme est exécuté par le dispositif de détection de défauts non francs dans un câble selon la revendication 11.

14. Support d'enregistrement lisible par un processeur sur lequel est enregistré un programme comportant des instructions pour l'exécution du procédé de détection de défauts non francs dans un câble selon l'une quelconque des revendications 1 à 10, lorsque le programme est exécuté par le dispositif de détection de défauts non francs dans un câble selon la revendication 11.

## Patentansprüche

1. Verfahren zur Detektion von weichen Fehlern in einer Übertragungsleitung (L), umfassend die folgenden Schritte:
- Erfassen (301) eines Messsignals (R), das als zeitliches Reflektogramm bezeichnet wird, das für die Reflexion eines Referenzsignals (S), das zuvor in die Leitung (L) eingespeist wird, charakteristisch ist,
- Berechnen (302) des Integrals (INT) des zeitlichen Reflektogramms,
- Auswählen (303), aus den Abtastwerten des Integrals (INT) des zeitlichen Reflektogramms, eines ersten Abtastwertes P₁, eines zweiten Abtastwertes P₂, der um eine erste Verzögerung k₁ in Bezug auf den ersten Abtastwert P₁ verzögert ist, und eines dritten Abtastwertes P₃, der um eine zweite Verzögerung k₂ in Bezug auf den zweiten Abtastwert P₂ verzögert ist,
- Berechnen (304) eines ersten Abstands gleich der Differenz als Absolutwert zwischen dem Wert des zweiten Abtastwertes P₂ und dem Wert von einem des ersten Abtastwertes P₁ oder des dritten Abtastwertes P₃,
- Berechnen (305) eines zweiten Abstands gleich der Differenz als Absolutwert zwischen dem Wert des ersten Abtastwertes P₁ und des dritten Abtastwertes P₃,
- Vornehmen eines ersten Vergleichs (307) des ersten Abstands zum zweiten Abstand, bewertet nach einem Bewertungskoeffizienten β,
- Abziehen, von dem Ergebnis des ersten Vergleichs (307), einer Information über das Vorliegen eines weichen Fehlers an einer Position des Kabels, die der zeitlichen Abszisse des zweiten Abtastwertes P₂ entspricht.

2. Verfahren zur Detektion von weichen Fehlern in einem Kabel nach Anspruch 1, ferner umfassend die folgenden Schritte:
- Vornehmen eines zweiten Vergleichs (306) des ersten Abstands mit einer Detektionsschwelle α,
- Abziehen, von dem Ergebnis des ersten Vergleichs (307) und des zweiten Vergleichs (306), einer Information über das Vorliegen eines weichen Fehlers an einer Position des Kabels, die der zeitlichen Abszisse des zweiten Abtastwertes P₂ entspricht.

3. Verfahren zur Detektion von weichen Fehlern in einem Kabel nach einem der vorhergehenden Ansprüche, wobei die erste Verzögerung k₁ und die zweite Verzögerung k₂ mindestens in Abhängigkeit von der Größe des ersten Spitzenwertes der Fehlanpassung, der an dem zeitlichen Reflektogramm gemessen wird, bestimmt werden.

4. Verfahren zur Detektion von weichen Fehlern in einem Kabel nach einem der vorhergehenden Ansprüche, wobei das Verfahren wiederholt wird, indem der erste Abtastwert P₁ an einer Vielzahl von Abtastwerten des Integrals (INT) des zeitlichen Reflektogramms variiert wird, indem die Werte der ersten Verzögerung k₁ und der zweiten Verzögerung k₂ im Verlauf der Wiederholungen gleichbleibend gehalten werden.

5. Verfahren zur Detektion von weichen Fehlern in einem Kabel nach einem der vorhergehenden Ansprüche, wobei die erste Verzögerung k₁ gleich der zweiten Verzögerung k₂ ist.

6. Verfahren zur Detektion von weichen Fehlern in einem Kabel nach einem der vorhergehenden Ansprüche, wobei die Detektionsschwelle α mindestens in Abhängigkeit von einem Parameter aus dem Signal-Rausch-Verhältnis auf dem ersten Signal r(t) und der Schwere des betreffenden weichen Fehlers konfiguriert wird.

7. Verfahren zur Detektion von weichen Fehlern in einem Kabel nach einem der vorhergehenden Ansprüche, wobei der Wert des Bewertungskoeffizienten β im Intervall [3; 9] liegt.

8. Verfahren zur Detektion von weichen Fehlern in einem Kabel nach einem der vorhergehenden Ansprüche, wobei das zeitliche Reflektogramm durch die Interkorrelation zwischen dem ersten Messsignal r(t) und dem Referenzsignal s(t) ersetzt wird.

9. Verfahren zur Detektion von weichen Fehlern in einem Kabel nach einem der vorhergehenden Ansprüche, umfassend einen Diagnoseschritt, der darin besteht, auf das Vorliegen eines weichen Fehlers an einer Position des Kabels, die der zeitlichen Abszisse des zweiten Abtastwertes P₂ entspricht, zu schließen, wenn der erste Abstand über der Detektionsschwelle α liegt und wenn der erste Abstand über dem zweiten Abstand liegt, der durch den Bewertungskoeffizienten β bewertet wurde.

10. Verfahren zur Detektion von weichen Fehlern in einem Kabel nach einem der vorhergehenden Ansprüche, umfassend einen Diagnoseschritt, der darin besteht, auf das Fehlen eines weichen Fehlers an einer Position des Kabels, die der zeitlichen Abszisse des zweiten Abtastwertes P₂ entspricht, zu schließen, wenn der erste Abstand unter der Detektionsschwelle α liegt und wenn der erste Abstand unter dem zweiten Abstand liegt, der durch den Bewertungskoeffizienten β bewertet wurde.

11. Vorrichtung zur Detektion von weichen Fehlern in einem Kabel (CA), umfassend ein Messgerät (MI) zum Messen, an einer Stelle des Kabels (CA), eines sich in dem Kabel rückwärts ausbreitenden Signals, und einen Rechner (MC), der dafür konfiguriert ist, das Verfahren zur Detektion von weichen Fehlern in einem Kabel nach einem der Ansprüche 1 bis 10 auszuführen.

12. Reflektometriesystem, umfassend eine Vorrichtung (GS) zum Einspeisen, an einer Stelle des Kabels, eines Referenzsignals und eine Vorrichtung zur Detektion von weichen Fehlern in einem Kabel (CA) nach Anspruch 11.

13. Computerprogramm, umfassend Anweisungen zum Ausführen des Verfahrens zur Detektion von weichen Fehlern in einem Kabel nach einem der Ansprüche 1 bis 10, wenn das Programm von der Vorrichtung zur Detektion von weichen Fehlern in einem Kabel nach Anspruch 11 ausgeführt wird.

14. Speichermedium, das von einem Prozessor lesbar ist, auf dem ein Programm gespeichert ist, das Anweisungen zum Ausführen des Verfahrens zur Detektion von weichen Fehlern in einem Kabel nach einem der Ansprüche 1 bis 10 umfasst, wenn das Programm von der Vorrichtung zur Detektion von weichen Fehlern in einem Kabel nach Anspruch 11 ausgeführt wird.

## Claims

1. A method for detecting soft faults in a transmission line (L) comprising the following steps:
- acquiring (301) a measurement signal (R), called time-domain reflectogram, characteristic of the reflection of a reference signal (S) previously injected into the line (L),
- calculating (302) the integral (INT) of the time-domain reflectogram,
- selecting (303), from the samples of the integral (INT) of the time-domain reflectogram, a first sample P1, a second sample P₂, delayed by a first delay k₁ relative to the first sample P₁, and a third sample P₃, delayed by a second delay k₂ relative to the second sample P₂,
- calculating (304) a first distance equal to the difference in absolute value between the value of the second sample P₂ and the value of either one of the first sample P₁ or of the third sample P₃,
- calculating (305) a second distance equal to the difference in absolute value between the value of the first sample P₁ and of the third sample P₃,
- performing a first comparison (307) of the first distance to the second distance weighted by a weighting coefficient β,
- deducing from the result of the first comparison (307) a piece of information on the existence of a soft fault at a position of the cable corresponding to the time-domain abscissa of the second sample P₂.

2. The method for detecting soft faults in a cable according to claim 1, further comprising the following steps:
- performing a second comparison (306) of the first distance with a detection threshold α,
- deducing from the result of the first comparison (307) and of the second comparison (306) a piece of information on the existence of a soft fault at a position of the cable corresponding to the time-domain abscissa of the second sample P₂.

3. The method for detecting soft faults in a cable according to one of the preceding claims, wherein the first delay k₁ and the second delay k₂ are determined at least as a function of the width of the first maladaptation peak measured on the time-domain reflectogram.

4. The method for detecting soft faults in a cable according to one of the preceding claims, wherein the method is iterated by varying the first sample P₁ over a plurality of samples of the integral (INT) of the time-domain reflectogram by retaining the values of the first delay k₁ and of the second delay k₂ that are fixed during the iterations.

5. The method for detecting soft faults in a cable according to one of the preceding claims, wherein the first delay k₁ is equal to the second delay k₂.

6. The method for detecting soft faults in a cable according to one of the preceding claims, wherein the detection threshold α is configured at least as a function of a parameter out of the signal-to-noise ratio on the first signal r(t) and the severity of the targeted soft fault.

7. The method for detecting soft faults in a cable according to one of the preceding claims, wherein the value of the weighting coefficient β lies within the interval [3; 9].

8. The method for detecting soft faults in a cable according to one of the preceding claims, wherein the time-domain reflectogram is replaced by the cross-correlation between the first measurement signal r(t) and the reference signal s(t).

9. The method for detecting soft faults in a cable according to one of the preceding claims, comprising a diagnostic step of concluding on the presence of a soft fault at a position of the cable corresponding to the time-domain abscissa of the second sample P₂ if the first distance is greater than the detection threshold α and if the first distance is greater than the second distance weighted by the weighting coefficient β.

10. The method for detecting soft faults in a cable according to one of the preceding claims, comprising a diagnostic step of concluding on the absence of a soft fault at a position of the cable corresponding to the time-domain abscissa of the second sample P₂ if the first distance is less than the detection threshold α and if the first distance is less than the second distance weighted by the weighting coefficient β.

11. A device for detecting soft faults in a cable (CA) comprising an apparatus (MI) for measuring, at a point of the cable (CA), a signal back-propagated in the cable and a computer (MC) configured to execute the method for detecting soft faults in a cable according to any one of claims 1 to 10.

12. A reflectometry system comprising a device (GS) for injecting, at a point of the cable, a reference signal, and a device for detecting soft faults in a cable (CA) according to claim 11.

13. A computer program comprising instructions for the execution of the method for detecting soft faults in a cable according to any one of claims 1 to 10, when the program is run by the device for detecting soft faults in a cable according to claim 11.

14. A processor-readable storage medium on which is stored a program comprising instructions for the execution of the method for detecting soft faults in a cable according to any one of claims 1 to 10, when the program is run by the device for detecting soft faults in a cable according to claim 11.
